# EUROPEAN PATENT APPLICATION

(11) **EP 4 033 489 A1**
(43) Date of publication of application: **27.07.2022**
(21) Application number: 21853076.4
(22) Date of filing: 05.02.2021
(51) Int. Cl.: G11C 7/10, G11C 11/4076

(54) **STORAGE SYSTEM**

(30) Priority: 03.08.2020 CN 202010766270
(71) Applicant: Changxin Memory Technologies, Inc., Hefei, Anhui 230601 (CN)
(72) Inventor: NING, Shuliang, Hefei, Anhui 230601 (CN)
(74) Representative: Lavoix
(86) International application number: PCT/CN2021/075455
(87) International publication number: WO 2022/027947

(57) **Abstract**

The present application provides a storage system, including a plurality of storage chips, each storage chip including a data output unit, the data output units sharing a power supply and a ground terminal, and the data output unit including: a pull-up unit, having a control terminal, a first terminal and a second terminal, a first input signal being inputted to the control terminal, the first terminal being electrically connected to the power supply, the second terminal being connected to an output terminal of the data output unit, and the pull-up unit being a first NMOS transistor; and a pull-down unit, having a control terminal, a first terminal and a second terminal, a second input signal being inputted to the control terminal, the first terminal being electrically connected to the ground terminal, and the second terminal being connected to the output terminal of the data output unit. The present application has advantages of increasing a data transmission speed and improving the performance of the storage system. The data output units of the storage chip share the power supply and the ground terminal, thereby simplifying the layout and improving the space utilization.

## Description

### CROSS-REFERENCE TO RELATED APPLICATION

This application claims priority to Chinese Patent Application No. 202010766270.9, entitled "STORAGE SYSTEM" and filed on August 3, 2020, the entire contents of which are incorporated herein by reference.

### TECHNICAL FILED

The present application relates to the field of semiconductor storage, in particular to a storage system.

### BACKGROUND

A semiconductor storage system is a memory component configured to store all kinds of data information. Data input and output are generally needed between the semiconductor storage system and a control system. However, with the development of storage systems, users have increasingly higher requirements for a data transmission rate, and an existing data transmission rate cannot meet the requirements.

Therefore, it is an urgent problem to be solved currently to provide a storage system with a high transmission rate.

### SUMMARY

The technical problem to be solved in the present application is to provide a storage system that can have a high data transmission rate, so as to meet users' requirements.

To solve the above problem, the present application provides a storage system, including a plurality of storage chips, each storage chip including a data output unit, the data output units sharing a power supply and a ground terminal, and the data output unit including: a pull-up unit, having a control terminal, a first terminal and a second terminal, a first input signal being inputted to the control terminal, the first terminal being electrically connected to the power supply, the second terminal being connected to an output terminal of the data output unit, and the pull-up unit being a first NMOS transistor; and a pull-down unit, having a control terminal, a first terminal and a second terminal, a second input signal being inputted to the control terminal, the first terminal being electrically connected to the ground terminal, and the second terminal being connected to the output terminal of the data output unit.

Further, the pull-down unit is a second NMOS transistor.

Further, a width of the first NMOS transistor is greater than that of the second NMOS transistor.

Further, the storage system further includes a control chip, and the output terminals of at least some of the data output units share a same conductive structure and are electrically connected to the control chip.

Further, the storage chips are stacked.

Further, the data output unit further includes a first switch unit and a second switch unit, the first terminal of the pull-up unit is electrically connected to the power supply through the first switch unit, and the first terminal of the pull-down unit is electrically connected to the ground terminal through the second switch unit.

Further, an enable signal controls the first switch unit and the second switch unit to be turned on or off to selectively electrically connect the data output units sharing the same conductive structure with the control chip.

Further, the first switch unit is a first transistor, the first transistor includes a control terminal, a first terminal and a second terminal, the enable signal is inputted to the control terminal, the first terminal is electrically connected to the power supply, and the second terminal is electrically connected to the first terminal of the pull-up unit.

Further, the second switch unit is a second transistor, the second transistor includes a control terminal, a first terminal and a second terminal, the enable signal is inputted to the control terminal, the first terminal is electrically connected to the ground terminal, and the second terminal is electrically connected to the first terminal of the pull-down unit.

Further, the first transistor is a third NMOS transistor, and the second transistor is a fourth NMOS transistor.

Further, the control chip also includes a data input unit, the data input unit of the control chip being of the same structure as a data input unit of the storage chip.

Further, the first input signal and the second input signal are complementary signals.

Further, the data output unit further includes an inverter, the first input signal is inputted to the control terminal of the pull-up unit through the inverter, or the second input signal is inputted to the control terminal of the pull-down unit through the inverter.

Further, a voltage corresponding to a high level of an output signal of the data output unit is less than a power supply voltage.

Further, the storage system further includes a serializer, and data of the storage system, after parallel-to-serial conversion by the serializer, is inputted to the pull-up unit and the pull-down unit as the first input signal and the second input signal.

Further, the storage chip further includes a data input unit, the data input unit is configured to receive data.

Further, the data input unit includes a buffer and a deserializer, and the data is inputted to the storage system through the buffer and the deserializer.

Further, the data input unit includes: a third switch unit; a fourth switch unit; a pull-up unit, having a control terminal, a first terminal and a second terminal, the first input signal being inputted to the control terminal, the first terminal being electrically connected to the power supply through the third switch unit, and the second terminal being connected to an output terminal of the data input unit; and a pull-down unit, having a control terminal, a first terminal and a second terminal, the second input signal being inputted to the control terminal, the first terminal being electrically connected to the ground terminal through the fourth switch unit, and the second terminal being connected to the output terminal of the data input unit.

The present application has the following advantages. The pull-up unit and the pull-down unit are provided, wherein the pull-up unit is an NMOS transistor, so that a voltage of the data output unit can be effectively accelerated from low to high or from high to low; that is, the time of conversion of the voltage of the data output unit from low to high or from high to low is reduced, thereby increasing a data transmission speed and improving the performance of the storage system. At the same time, the data output units of the storage chips in the storage system according to the present application share the power supply and the ground terminal, thereby simplifying the layout and improving the space utilization.

### BRIEF DESCRIPTION OF THE DRAWINGS

Figure 1 is a structural diagram of a framework of an embodiment of a storage system according to the present application;
Figure 2 is a schematic diagram of data transmission of a storage chip and a control chip in the storage system according to the present application;
Figure 3 is a schematic structural diagram of a data port arranged on the storage chip in the storage system according to the present application;
Figure 4 is a schematic diagram of a circuit structure of a first embodiment of a data output unit in the storage system according to the present application;
Figure 5 is a schematic circuit diagram of a first embodiment of a data output unit of the storage chip and the control chip in the storage system according to the present application;
Figure 6 is a schematic circuit diagram of a second embodiment of the data output unit of the storage chip and the control chip in the storage system according to the present application;
Figure 7 is a schematic circuit diagram of a third embodiment of the data output unit of the storage chip and the control chip in the storage system according to the present application;
Figure 8 is a schematic diagram of a circuit structure of a second embodiment of the data output unit in the storage system according to the present application; and
Figure 9 is a schematic diagram of a circuit structure of an embodiment of a data input unit in the storage system according to the present application.

### DETAILED DESCRIPTION OF THE EMBODIMENTS

Embodiments of the storage system according to the present application are described in detail below with reference to the accompanying drawings.

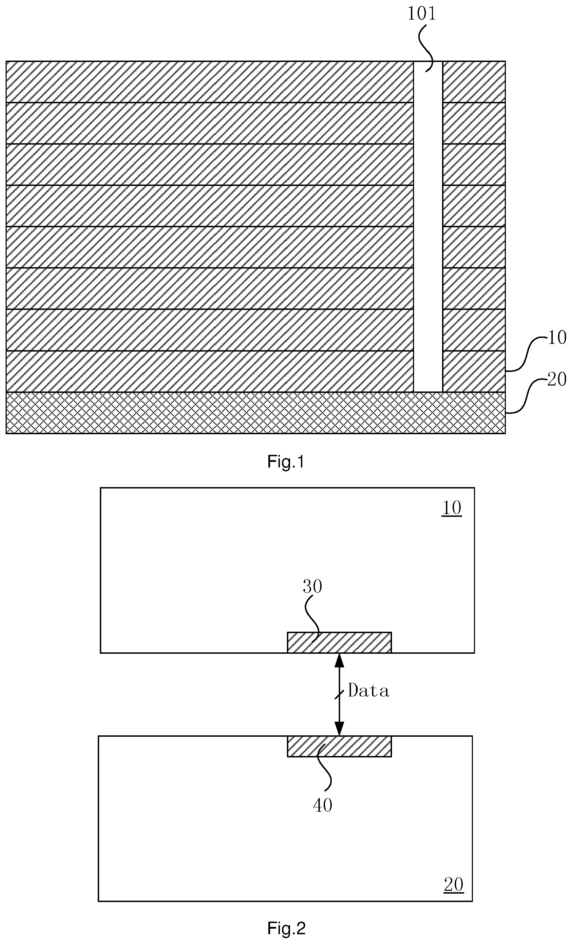

Figure 1 is a structural diagram of a framework of an embodiment of a storage system according to the present application. Referring to Figure 1, the storage system according to the present application includes a plurality of storage chips 10. The storage chip 10 is an existing storage structure capable of data writing, data reading and/or data deletion.

In this embodiment, the storage system further includes a control chip 20. The storage chip 10 is stacked on the control chip 20. Eight storage chips 10 are schematically plotted in Figure 1, which are stacked on the control chip 20. In other embodiments of the present application, a number of the storage chip 10 may be set according to a user requirement.

Figure 2 is a schematic diagram of data transmission of a storage chip and a control chip in the storage system. The storage chip 10 includes a data port 30, and the control chip 20 also includes a data port 40. The data port 30 is electrically connected to the data port 40, so that the storage chip 10 and the control chip 20 transmit data through the data port 30 and the data port 40.

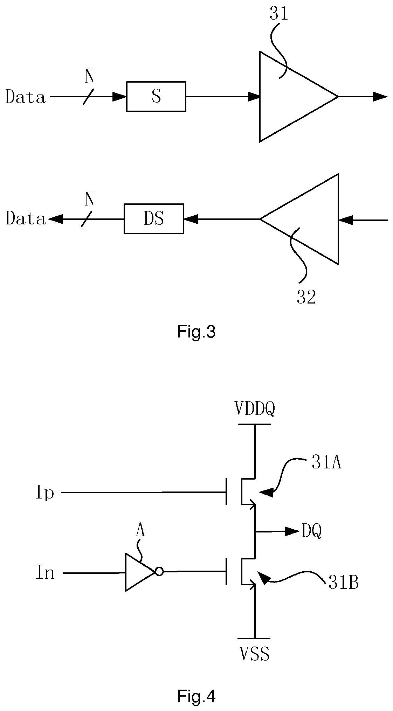

Figure 3 is a schematic structural diagram of the data port 30 arranged on the storage chip 10. Referring to Figure 3, in this embodiment, the data port 30 arranged on the storage chip 10 includes a data output unit 31. Data of the storage chip 10 is transmitted externally through the data output unit 31, for example, to the control chip 20. Further, the data port 30 further includes a data input unit 32. External data is transmitted through the data input unit 32 to the storage chip 10. In this embodiment, the data input unit 32 includes a buffer, and the external data (for example, data of the control chip 20) is inputted to the storage system through the buffer.

Further, in this embodiment, the storage system further includes a serializer S, and data of the storage system, after parallel-to-serial conversion by the serializer S, is inputted to the data output unit 31 as an input signal. The storage system further includes a deserializer DS, and data outputted by the buffer, after serial-to-parallel conversion by the deserializer DS, is inputted to the storage system.

Figure 4 is a schematic diagram of a circuit structure of a first embodiment of the data output unit 31. Referring to Figure 4, the data output unit 31 includes a pull-up unit 31A and a pull-down unit 31B.

The pull-up unit 31A has a control terminal, a first terminal and a second terminal. A first input signal of the storage chip 10 is inputted to the control terminal, the first terminal is electrically connected to a power supply VDDQ, and the second terminal is connected to an output terminal DQ of the data output unit 31. The output terminal DQ is electrically connected to an external structure; for example, the output terminal DQ is electrically connected to the control chip 20 to transmit data from the storage chip 10 to the control chip 20. The pull-up unit is a first NMOS transistor. In the first NMOS transistor, a gate terminal is the control terminal, one of a source terminal and a drain terminal is the first terminal, and the other of the source terminal and the drain terminal is the second terminal.

The pull-down unit 31B has a control terminal, a first terminal and a second terminal. A second input signal of the storage chip 10 is inputted to the control terminal, the first terminal is electrically connected to a ground terminal VSS, and the second terminal is connected to the output terminal DQ of the data output unit. In this embodiment, the pull-down unit 31B and the pull-up unit 31A are transistors of the same type. That is, the pull-down unit 31B is a second NMOS transistor. In the second NMOS transistor, a gate terminal is the control terminal, one of a source terminal and a drain terminal is the first terminal, and the other of the source terminal and the drain terminal is the second terminal.

In this embodiment, the first input signal and the second input signal are complementary signals. For example, the first input signal is a positive input signal Ip, the second input signal is a negative input signal In, and they are complementary to each other, so as to output a complete signal at the output terminal DQ.

Further, the data output unit 31 further includes an inverter A. The first input signal is inputted to the control terminal of the pull-up unit 31A through the inverter A, or the second input signal is inputted to the control terminal of the pull-down unit 31B through the inverter A. In this embodiment, the first input signal and the second input signal are complementary signals, the pull-up unit 31A is an NMOS transistor, and the pull-down unit 31B is also an NMOS transistor; therefore, in order to ensure the integrity of an output signal, one of the pull-up unit 31A and the pull-down unit 31B is provided with the inverter A, so as to guarantee the integrity of the signal outputted by the output terminal DQ. In this embodiment, the inverter A is arranged on a branch where the pull-down unit 31B is located; that is, the second input signal is inputted to the control terminal of the pull-down unit 31B through the inverter A. No inverter is arranged on a branch where the pull-up unit 31A is located; that is, the first input signal is directly inputted to the control terminal of the pull-up unit 31A. In other embodiments of the present application, an inverter may be arranged on the branch where the pull-up unit 31A is located, while no inverter is arranged on the branch where the pull-down unit 31B is located.

Further, in this embodiment, a voltage corresponding to a high level of an output signal of the output terminal DQ of the data output unit 31 is less than a power supply VDDQ voltage. That is, a voltage of the output terminal DQ is not required to be increased to the power supply VDDQ voltage, which reduces the time of conversion between a low level and a high level and increases a data transmission rate.

Further, a width of the first NMOS transistor is greater than that of the second NMOS transistor, and the first NMOS transistor and the second NMOS transistor operate in a linear region, which can further increase the data transmission rate and improve the performance of the storage system.

The data output unit of the storage system according to the present application is provided with the pull-up unit 31A and the pull-down unit 31B, wherein the pull-up unit 31A is an NMOS transistor, so that a voltage of the data output unit can be effectively accelerated from low to high or from high to low; that is, the time of conversion of the voltage of the data output unit from low to high or from high to low is reduced, thereby increasing the data transmission speed and improving the performance of the storage system.

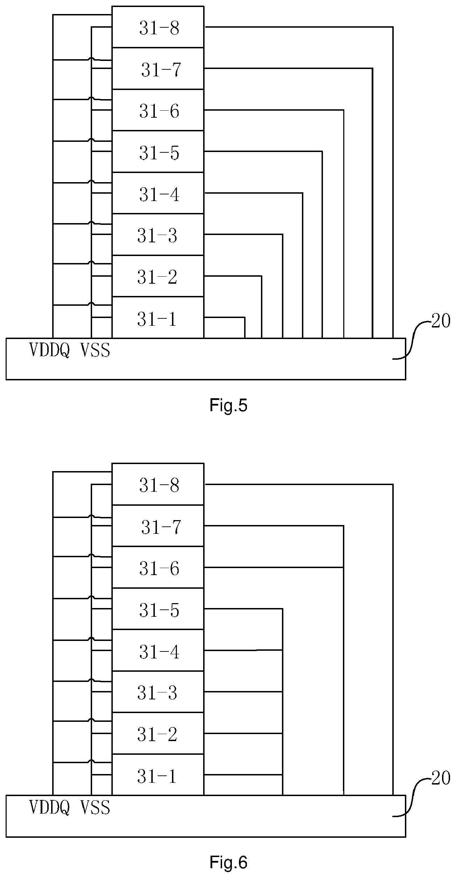

Figure 5 is a schematic circuit diagram of a first embodiment of a data output unit of the storage chip and the control chip in the storage system according to the present application. Referring to Figure 5, the data output units 31 share the power supply VDDQ and the ground terminal VSS, so as to simplify the layout and improve the space utilization. In the first embodiment, all the data output units 31 share the power supply VDDQ and the ground terminal VSS. In other embodiments of the present application, at least some of the data output units 31 share the power supply VDDQ and the ground terminal VSS.

Further, the output terminal DQ of the data output unit 31 is connected to the control chip 20 through a conductive structure. The conductive structure may be a through-silicon-via (TSV) structure 101 as shown in FIG. 1. In the first embodiment, the output terminal DQ of each data output unit 31 is connected to the control chip 20 through one TSV structure 101. That is, the output terminals DQ of the data output units 31 do not share the TSV structure 101. Specifically, data output units 31-1, 31-2, 31-3, 31-4, 31-5, 31-6, 31-7 and 31-8 are connected to the control chip 20 through different TSV structures respectively.

Figure 6 is a schematic circuit diagram of a second embodiment of the data output unit of the storage chip and the control chip in the storage system according to the present application. Referring to Figure 6, in the second embodiment, the output terminals DQ of some of the data output units 31 share the same conductive structure and are electrically connected to the control chip 20. Specifically, in the second embodiment, eight data output units 31 are schematically plotted. The data output units 31-1, 31-2, 31-3, 31-4 and 31-5 share the same conductive structure, the data output units 31-6 and 31-7 share another conductive structure, and the data output unit 31-8 uses a conductive structure alone.

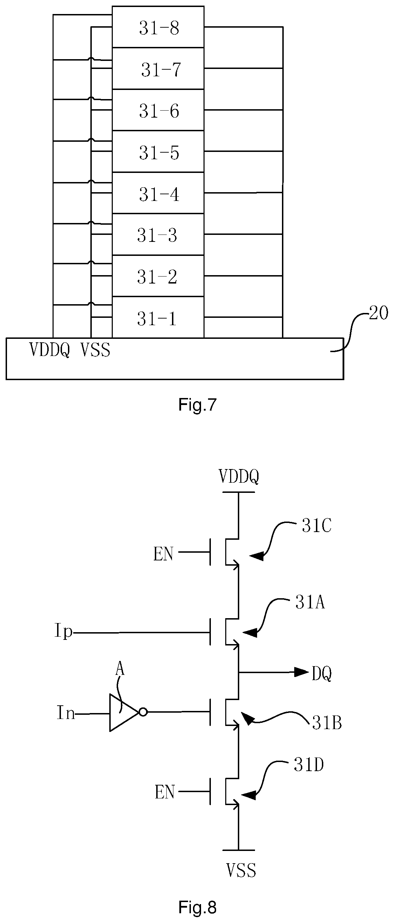

Figure 7 is a schematic circuit diagram of a third embodiment of the data output unit of the storage chip and the control chip in the storage system according to the present application. Referring to Figure 7, in the third embodiment, the output terminals DQ of all the data output units 31 share the same conductive structure and are electrically connected to the control chip 20. Specifically, the data output units 31-1, 31-2, 31-3, 31-4, 31-5, 31-6, 31-7 and 31-8 share the same conductive structure.

For the situation where the output terminals DQ of part or all of the data output units 31 share the same conductive structure and are electrically connected to the control chip 20 (as shown in Figure 6 and Figure 7), when the storage chip 10 where the output terminal DQ of a certain data output unit 31 is located is required to transmit data with the control chip 20, other storage chips sharing the same conductive structure are required to cut off the connection with the control chip 20 to avoid affecting the data transmission of the storage chip 10. Therefore, switch units are added to the data output unit of the storage chip of the storage system according to the present application, so as to control ON and OFF of the data output unit 31, thereby avoiding affecting the data transmission of the storage chip 10.

Specifically, Figure 8 is a schematic diagram of a circuit structure of a second embodiment of the data output unit 31 in the storage system according to the present application. Referring to Figure 8, the data output unit 31 not only includes the pull-up unit 31A and the pull-down unit 31B, but also includes a first switch unit 31C and a second switch unit 31D.

The first terminal of the pull-up unit 31A is electrically connected to the power supply VDDQ through the first switch unit 31C, and the first terminal of the pull-down unit 31B is electrically connected to the ground terminal VSS through the second switch unit 31D. In the present application, the data output unit 31 can be switched between output of data and a high-impedance state (that is, no output of data) by turning on and turning off the first switch unit 31C and the second switch unit 31D. Specifically, when the first switch unit 31C and the second switch unit 31D are turned on, the data output unit 31 can output data to the control chip through the TSV structure; and when the first switch unit 31C and the second switch unit 31D are turned off, the data output unit 31 cannot output data to the control chip and presents the high-impedance state.

Further, in this embodiment, the first switch unit 31C is a first transistor. The first transistor includes a control terminal, a first terminal and a second terminal. An enable signal EN is inputted to the control terminal to control ON and OFF of the first switch unit 31C. The first terminal is electrically connected to the power supply VDDQ. The second terminal is electrically connected to the first terminal of the pull-up unit 31A. In this embodiment, the first transistor is a third NMOS transistor. In the third NMOS transistor, a gate terminal is the control terminal, one of a source terminal and a drain terminal is the first terminal, and the other of the source terminal and the drain terminal is the second terminal. In other embodiments of the present application, the first transistor may also be a PMOS transistor. In the PMOS transistor, a gate terminal is the control terminal, one of a source terminal and a drain terminal is the first terminal, and the other of the source terminal and the drain terminal is the second terminal.

Further, in this embodiment, the second switch unit 31D is a second transistor. The second transistor includes a control terminal, a first terminal and a second terminal. The enable signal EN is inputted to the control terminal to control ON and OFF of the second switch unit 31D. The first terminal is electrically connected to the ground terminal VSS. The second terminal is electrically connected to the first terminal of the pull-down unit 31B. In this embodiment, the second transistor is a fourth NMOS transistor. In the fourth NMOS transistor, a gate terminal is the control terminal, one of a source terminal and a drain terminal is the first terminal, and the other of the source terminal and the drain terminal is the second terminal. In other embodiments of the present application, the second transistor may also be a PMOS transistor. In the PMOS transistor, a gate terminal is the control terminal, one of the source terminal and the drain terminal is the first terminal, and the other of the source terminal and the drain terminal is the second terminal.

In this embodiment, the pull-up unit 31A, the pull-down unit 31B, the first switch unit 31C and the second switch unit 31D are all NMOS transistors and may share a semiconductor structure, which greatly simplifies the layout and saves a manufacturing process.

The following illustrates how the first switch unit and the second switch unit are controlled to realize data transmission in the situation where the output terminals DQ of some of the data output units 31 share the same conductive structure and are electrically connected to the control chip 20 (as shown in Figure 6). When the storage chip 10 where the output terminal DQ of the data output unit 31-1 is located is required to transmit data with the control chip 20, the enable signal controls the first switch unit and the second switch unit of the data output unit 31-1 to be turned on and controls the first switch units and the second switch units of the data output units 31-2, 31-3, 31-7 and 31-8 to be turned off, so as to cut off the connection with the control chip 20 to avoid affecting the data transmission of the storage chip 10 where the data output unit 31-1 is located. When the storage chip 10 where the output terminal DQ of the data output unit 31-2 is located is required to transmit data with the control chip 20, the enable signal controls the first switch unit and the second switch unit of the data output unit 31-2 to be turned on and controls the first switch units and the second switch units of the data output units 31-1, 31-3, 31-7 and 31-8 to be turned off, so as to cut off the connection with the control chip 20 to avoid affecting the data transmission of the storage chip 10 where the data output unit 31-1 is located. The control over other data output units can be obtained with reference to the above description.

In the above embodiment of the present application, the data input unit 32 is a buffer. In another embodiment of the present application, the data input unit 32 is of the same structure as the data output unit 31.

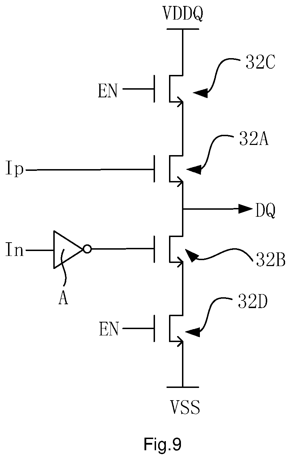

Specifically, refer to Figure 9, which is a schematic diagram of a circuit structure of an embodiment of the data input unit 32 of the storage system according to the present application. The data input unit 32 includes a pull-up unit 32A, a pull-down unit 32B, a third switch unit 32C and a fourth switch unit 32D.

The pull-up unit 32A has a control terminal, a first terminal and a second terminal. The first input signal of the external structure (for example, the control chip 20) is inputted to the control terminal, the first terminal is electrically connected to the power supply VDDQ through the third switch unit 32C, and the second terminal is connected to an output terminal DQ of the data input unit 32. The signal of the output terminal DQ is inputted to the storage chip 10. In this embodiment, the pull-up unit 32A is an NMOS transistor.

The pull-down unit 32B has a control terminal, a first terminal and a second terminal. The second input signal of the external structure (for example, the control chip 20) is inputted to the control terminal, the first terminal is electrically connected to the ground terminal VSS through the fourth switch unit 32D, and the second terminal is connected to the output terminal DQ of the data input unit. In this embodiment, the pull-down unit 32B is an NMOS transistor. In other embodiments of the present application, the pull-down unit 32B may also be a PMOS transistor.

The first input signal and the second input signal are complementary signals. For example, the first input signal is a positive input signal Ip, the second input signal is a negative input signal In, and they are complementary to each other, so as to output a complete signal at the output terminal DQ.

The data input unit of the storage chip 10 of the storage system according to the present application is provided with the pull-up unit 32A and the pull-down unit 32B, and the pull-up unit 32A is an NMOS transistor, so that a voltage of the data input unit can be effectively accelerated from low to high or from high to low; that is, the time of conversion of the voltage of the data input unit from low to high or from high to low is reduced, thereby greatly increasing the data transmission speed and improving the performance of the storage system.

In the present application, the data input unit 32 can be switched between input of data and a high-impedance state (that is, no input of data) by turning on and turning off the third switch unit 32C and the fourth switch unit 32D. Specifically, when the third switch unit 32C and the fourth switch unit 32D are turned on, the data input unit 32 can input data; and when the third switch unit 32C and the fourth switch unit 32D are turned off, the data input unit 32 cannot input data and presents the high-impedance state.

Further, in this embodiment, the third switch unit 32C and the fourth switch unit 32D are both NMOS transistors, and then the pull-up unit 32A, the pull-down unit 32B, the third switch unit 32C and the fourth switch unit 32D can share a semiconductor structure with one another, which greatly simplifies the layout and saves the manufacturing process.

Further, part or all of the data input units of the storage chips may also share the same conductive structure and be electrically connected to the control chip 20. The connection manners thereof are the same as the data output units are not described in detail.

The structure of the data port 30 in the storage chip 10 is described in the above embodiments. It may be understood that the data port 40 located in the control chip 20 may have the same structure as the data port 30 located in the storage chip 10. That is, the data output unit of the data port 40 located in the control chip 20 may also consist of a pull-up unit and a pull-down unit, thereby greatly increasing a rate at which data is transmitted from the control chip 20 to the storage chip 10 or other structural layers. The data input unit of the data port 40 located in the control chip 20 may also consist of a pull-up unit and a pull-down unit, thereby greatly increasing a rate at which data is transmitted from the external structure (such as the storage chip or other structural layers) to the control chip 20.

The above descriptions are only preferred implementations of the present application. It should be pointed out that, those of ordinary skill in the art may further make several improvements and modifications without departing from the principle of the present application. Such improvements and modifications should also fall within the protection scope of the present application.

## Claims

1. A storage system, comprising a plurality of storage chips, each storage chip comprising a data output unit, the data output units sharing a power supply and a ground terminal, and the data output unit comprising:
a pull-up unit, having a control terminal, a first terminal and a second terminal, a first input signal being inputted to the control terminal, the first terminal being electrically connected to the power supply, the second terminal being connected to an output terminal of the data output unit, and the pull-up unit being a first NMOS transistor; and
a pull-down unit, having a control terminal, a first terminal and a second terminal, a second input signal being inputted to the control terminal, the first terminal being electrically connected to the ground terminal, and the second terminal being connected to the output terminal of the data output unit.

2. The storage system according to claim 1, wherein the pull-down unit is a second NMOS transistor.

3. The storage system according to claim 2, wherein a width of the first NMOS transistor is greater than that of the second NMOS transistor.

4. The storage system according to claim 1, wherein the storage system further comprises a control chip, and the output terminals of at least some of the data output units share a same conductive structure and are electrically connected to the control chip.

5. The storage system according to claim 4, wherein the storage chips are stacked.

6. The storage system according to claim 4, wherein the data output unit further comprises a first switch unit and a second switch unit, the first terminal of the pull-up unit is electrically connected to the power supply through the first switch unit, and the first terminal of the pull-down unit is electrically connected to the ground terminal through the second switch unit.

7. The storage system according to claim 6, wherein an enable signal controls the first switch unit and the second switch unit to be turned on or off to selectively electrically connect the data output units sharing the same conductive structure with the control chip.

8. The storage system according to claim 7, wherein the first switch unit is a first transistor, the first transistor comprises a control terminal, a first terminal and a second terminal, the enable signal is inputted to the control terminal, the first terminal is electrically connected to the power supply, and the second terminal is electrically connected to the first terminal of the pull-up unit.

9. The storage system according to claim 8, wherein the second switch unit is a second transistor, the second transistor comprises a control terminal, a first terminal and a second terminal, the enable signal is inputted to the control terminal, the first terminal is electrically connected to the ground terminal, and the second terminal is electrically connected to the first terminal of the pull-down unit.

10. The storage system according to claim 9, wherein the first transistor is a third NMOS transistor, and the second transistor is a fourth NMOS transistor.

11. The storage system according to claim 4, wherein the control chip also comprises a data input unit, the data input unit of the control chip being of the same structure as a data input unit of the storage chip.

12. The storage system according to claim 1, wherein the first input signal and the second input signal are complementary signals.

13. The storage system according to claim 12, wherein the data output unit further comprises an inverter, the first input signal is inputted to the control terminal of the pull-up unit through the inverter, or the second input signal is inputted to the control terminal of the pull-down unit through the inverter.

14. The storage system according to claim 1, wherein a voltage corresponding to a high level of an output signal of the data output unit is less than a power supply voltage.

15. The storage system according to claim 1, wherein the storage system further comprises a serializer, and data of the storage system, after parallel-to-serial conversion by the serializer, is inputted to the pull-up unit and the pull-down unit as the first input signal and the second input signal.

16. The storage system according to claim 1, wherein the storage chip further comprises a data input unit, the data input unit is configured to receive data.

17. The storage system according to claim 16, wherein the data input unit comprises a buffer and a deserializer, and the data is inputted to the storage system through the buffer and the deserializer.

18. The storage system according to claim 16, wherein the data input unit comprises:
a third switch unit;
a fourth switch unit;
a pull-up unit, having a control terminal, a first terminal and a second terminal, the first input signal being inputted to the control terminal, the first terminal being electrically connected to the power supply through the third switch unit, and the second terminal being connected to an output terminal of the data input unit; and
a pull-down unit, having a control terminal, a first terminal and a second terminal, the second input signal being inputted to the control terminal, the first terminal being electrically connected to the ground terminal through the fourth switch unit, and the second terminal being connected to the output terminal of the data input unit.
